# EUROPÄISCHE PATENTSCHRIFT

(11) **EP 3 405 944 B1**
(45) Veröffentlichungstag und Bekanntmachung des Hinweises auf die Patenterteilung: **09.08.2023**
(21) Anmeldenummer: 17705016.8
(22) Anmeldetag: 13.01.2017
(51) Int. Cl.: G09G 5/00, G06F 3/14, H03M 13/19, G09G 5/395, G09G 5/36

(54) **VORRICHTUNG UND VERFAHREN ZUM ÜBERPRÜFEN EINER GÜLTIGKEIT VON BILDDATEN IN EINER ANZEIGEEINRICHTUNG UNTER EINBEZIEHUNG VON ÜBERPRÜFUNGSDATEN**
APPARATUS AND METHOD FOR CHECKING A VALIDITY OF IMAGE DATA IN A DISPLAY DEVICE BY INCLUDING CHECKING DATA
DISPOSITIF ET PROCÉDÉ DE CONTRÔLE D'UNE VALIDITÉ DE DONNÉES D'IMAGE DANS UN DISPOSITIF D'AFFICHAGE EN TENANT COMPTE DE DONNÉES DE CONTRÔLE

(30) Priorität: 21.01.2016 DE 102016200823
(43) Veröffentlichungstag der Anmeldung: 28.11.2018
(73) Patentinhaber: Robert Bosch GmbH, 70442 Stuttgart (DE)
(72) Erfinder: KATCHAN, Igor, 71229 Leonberg (DE); LINDNER, Markus, 70180 Stuttgart (DE)
(86) Internationale Anmeldenummer: PCT/EP2017/050698
(87) Internationale Veröffentlichungsnummer: WO 2017/125324

(56) Entgegenhaltungen:
- FR-A1- 2 908 225
- FR-B1- 2 908 225
- US-A1- 2008 101 467
- US-A1- 2008 297 436
- US-A1- 2009 063 935

## Beschreibung

### Stand der Technik

Um Sicherheitsanforderungen nach der ISO-Norm 26262 zu erfüllen, enthält eine Anzeigevorrichtung in einem Kraftfahrzeug in der Regel ein oder mehrere Überwachungsmodule, welche eine Berechnung und einen Vergleich von Prüfwerten zu in einem Display der Anzeigevorrichtung dargestellten Warnmeldungen durchführen. Bei einem durch den Prüfwertevergleich festgestellten Auftreten eines sicherheitskritischen Fehlers in der Darstellung einer Warnmeldung wird das Display deaktiviert. DE 10 2007 048 608 A1 beschreibt hierzu ein Verfahren zum Überprüfen einer Gültigkeit von Anzeigesignalen, beispielsweise für eine Überprüfung einer Gültigkeit von Bilddaten von Warnmeldungen.

Aus der US 2008/0297436 A1 ist ein Verfahren zur Kontrolle eines Head-up Displays bekannt, das ein Bild für einen Betrachter anzeigt.

Aus der FR2908225A1 ist eine Methode bekannt zum Verifizieren eines dargestellten Bildes.

Aus der US 2008/0101467 A1 ist ein Verfahren bekannt zur sicheren und effizienten Übertragung von Signalen.

Aus der US 2009/0063935 A1 ist ein Verfahren und System bekannt zur kabellosen Kommunikation von Videos.

Es können jedoch auch Fehler in einer Übertragung und Darstellung von Bilddaten zu Warnmeldungen auftreten, die keine oder kaum sichtbare Änderungen in sicherheitsrelevanten Teilen der Bilddaten hervorrufen und somit als nicht sicherheitskritisch einzustufen sind. In solchen Fällen ist eine Abschaltung des Displays der Anzeigevorrichtung unnötig, da keine Gefährdung im Sinne von ISO 26262 vorliegt.

### Offenbarung der Erfindung

Die Erfindung ist in den Ansprüchen 1 und 10 dargelegt.

### Vorteile der Erfindung

Die Erfindung betrifft ein Verfahren zum Überprüfen einer ersten Gültigkeit von Bilddaten, wobei die Bilddaten von einem Graphikprozessor zu einem Datenüberwachungsmodul übermittelt werden. Erfindungsgemäß werden zu den Bilddaten Überprüfungsdaten übermittelt und es wird eine erste Gültigkeit der Bilddaten nur dann festgestellt, wenn bei einer Überprüfung zumindest eines Teils der Bilddaten unter Einbeziehung der Überprüfungsdaten keine Fehler in dem Teil der Bilddaten festgestellt werden oder wenn bei der Überprüfung festgestellte Fehler in dem Teil der Bilddaten unter Berücksichtigung der Überprüfungsdaten zumindest in einem vorgegebenen Ausmaß behoben werden können.

Unter einem Graphikprozessor, auch GPU genannt, kann eine Vorrichtung verstanden werden, die zur Erzeugung und Übermittlung von Bilddaten eingerichtet ist. Unter einem Datenüberwachungsmodul kann insbesondere eine elektronische Einrichtung verstanden werden, die eingerichtet ist, empfangene Daten, insbesondere Bilddaten, auf eine Gültigkeit zu überprüfen. Unter Bilddaten sowie unter einem Bilddatum können insbesondere Daten bzw. ein Datum verstanden werden, welche Informationen für eine Darstellung eines Bildes umfassen, wobei die Bilddaten insbesondere Farbwerte für einzelne Pixel einer Anzeige umfassen. Unter Überprüfungsdaten können insbesondere Daten verstanden werden, welche Informationen zu einer Überprüfung einer Gültigkeit zumindest eines Teils anderer Daten tragen, insbesondere zur Überprüfung zumindest eines Teils von Bilddaten. Beispielsweise können die Überprüfungsdaten zu den Bilddaten redundante Daten umfassen. Beispielsweise können die Überprüfungsdaten auf einen verwendeten Fehlererkennungsalgorithmus abgestimmte Daten zu den zu überprüfenden Bilddaten umfassen. Unter einem Pixel kann insbesondere ein Bildelement, ein Bildpunkt, eine Bildzelle oder ein Flächenelement eines Displays oder Bildschirms verstanden werden. Ein Pixel kann hierbei insbesondere ausgebildet sein, Licht mehrerer bestimmter Farben, beispielsweise die Grundfarben Rot, Grün und/oder Blau und/oder einen Grauton, wiederzugeben. Insbesondere kann ein Pixel mehrere Subpixel umfassen, wobei die Subpixel ausgebildet sein können, Licht einer bestimmten Farbe, beispielsweise einer der Grundfarben Rot, Grün oder Blau oder eines Grautons, wiederzugeben.

Das erfindungsgemäße Verfahren hat den Vorteil, dass bei einer Übertragung von Bilddaten auftretende Fehler in dem überprüften Teil der Bilddaten unter Einbeziehung der Überprüfungsdaten festgestellt und zumindest in dem vorgegebenen Ausmaß behoben werden können. Unter dem vorgegebenen Ausmaß der Behebung festgestellter Fehler kann beispielsweise verstanden werden, dass Fehler aus einer ersten Menge von Fehlertypen behoben werden können und Fehler aus einer zweiten Menge von Fehlertypen nicht behoben werden können und somit das vorgegebene Ausmaß die erste Menge von Fehlertypen umfasst, wobei vorzugsweise ein Auftreten von Fehlertypen aus der zweiten Menge toleriert werden kann. Dies ist insbesondere dann von Vorteil, wenn die Fehlertypen aus der zweiten Menge auf eine Darstellung eines aus den Bilddaten generierten Bildes nur geringen Einfluss haben. Beispielsweise können die genannten Bilddaten deshalb nur einen geringen Einfluss haben, weil eine Veränderung dieser Bilddaten keine bedeutende und/oder insbesondere keine sicherheitsrelevante Änderung in der Darstellung des zugeordneten Bildes verursacht. Eine solche geringfügige oder unwesentliche Änderung des Bildes ist beispielsweise hinnehmbar, solange die Anforderungen der ISO-Norm 26262 erfüllt bleiben. Dies ist insbesondere dann der Fall, wenn die Änderung des dargestellten Bildes keine bedeutende Änderung in der Wahrnehmung, insbesondere aufgrund von physiologischen Verhältnissen der menschlichen Sehwahrnehmung, durch den menschlichen Betrachter verursacht. Unter dem vorgegebenen Ausmaß der Behebung festgestellter Fehler kann beispielsweise auch verstanden werden, dass pro vorgegebener Menge an Bilddaten eine vorgegebene Anzahl von Fehlern behoben werden können. Wenn Bilddaten in Form von Bytes übertragen werden, kann das vorgegebene Ausmaß beispielsweise darin bestehen, dass eine vorgegebenen Anzahl fehlerhafter Bits je Byte behoben werden können.

Ein Einsatz dieses Verfahrens ist insbesondere bei Anzeigeeinrichtungen eines Kraftfahrzeugs von Vorteil, da bei solch einem Einsatz eine korrekte Darstellung von über Bilddaten übermittelten Warnsignalen gemäß ISO-Norm 26262 besonders wichtig ist. Durch das erfindungsgemäße Verfahren kann dabei vorteilhafterweise eine Abschaltung eines Displays der Anzeigevorrichtung bei Auftreten von Fehlern in den Bilddaten in vielen Fällen verhindert werden.

Vorzugsweise werden alle übermittelten Bilddaten unter Einbeziehung der übermittelten Überprüfungsdaten überprüft.

In einer vorteilhaften Ausgestaltung des Verfahrens werden die Überprüfungsdaten zumindest teilweise während einer Zeitdauer, in welcher keine Bilddaten übermittelt werden - auch Leerzeit, Dunkelzeit oder Display-Blanking-Bereich genannt -, vor oder nach zumindest einer teilweisen Übermittlung von Bilddaten übermittelt. Für die Darstellung eines Bildes in einem Display der Anzeigevorrichtung werden in der Regel zeitlich beabstandete Bilddatenpakete übermittelt, wobei zwischen den Paketen während einer sogenannten Leerzeit keine Datenübertragung stattfindet. Durch eine Ausnutzung dieser Leerzeit zur Übertragung der Überprüfungsdaten wird somit vorteilhafterweise eine Übertragung der Bilddatenpakete nicht verzögert.

In einer vorteilhaften Weiterbildung der Erfindung wird zumindest ein Bilddatum vor der Übermittlung durch ein Überprüfungsdatum ersetzt. Dies hat den Vorteil, dass der insgesamt zu übermittelnde Datenstrom trotz zusätzlicher Übermittlung von Überprüfungsdaten in seinem Volumen nicht erhöht wird. Diese Weiterbildung ist insbesondere dann vorteilhaft, wenn ein Teil der Bilddaten nur einen unwesentlichen oder fast gar kein Einfluss auf eine Darstellung eines Bildes in dem Display haben und somit auf eine Übermittlung dieser Daten verzichtet werden kann. Diese Weiterbildung ist insbesondere bei der Darstellung von Warnsymbolen vorteilhaft. Warnsymbole weisen in der Regel eine einfache Bildstruktur auf, sodass im Vergleich zu Darstellungen anderer Bilder in einer Anzeigevorrichtung weniger Information pro Displayfläche übertragen werden müssen und somit vorteilhafterweise ein wesentlicher Teil der Bilddaten für die Darstellung des Warnsymbols ohne Beeinträchtigung der Darstellung des Warnsymbols durch Überprüfungsdaten ersetzt werden kann.

Gemäß einer weiteren vorteilhaften Ausgestaltung des Verfahrens besteht der Teil der Bilddaten, die durch Überprüfungsdaten ersetzt werden, aus Bits mit einer Bitwertigkeit unterhalb eines vorgegebenen Schwellwerts. Unter Bitwertigkeit ist hier insbesondere eine Wertung der Bits nach Relevanz für eine Darstellung eines der den Bilddaten zugehörigen Bildes in der Anzeigevorrichtung zu verstehen. Ferner kann unter Bitwertigkeit auch eine Wertung der Bits abhängig davon verstanden werden, wie groß der Einfluss der Bits über die Darstellung eines Bildes auf die Sehwahrnehmung dieses Bildes durch den menschlichen Beobachter zur Folge hat. Beispielsweise kann die Bitwertigkeit so festgelegt werden, dass sie mit einer Intensität einer Sehwahrnehmung eines menschlichen Betrachters korreliert. Bits mit einer geringen Wertigkeit haben somit auf die Darstellung des Bildes beziehungsweise auf die menschliche Wahrnehmung des Bildes geringen oder gar keinen Einfluss und können daher vorteilhafterweise durch Überprüfungsdaten ersetzt werden, ohne dass der insgesamt zu übermittelnde Datenstrom vergrößert wird.

In einer vorteilhaften Weiterbildung der Erfindung sind die Bilddaten Pixeln von Bildpunkten einer Anzeigevorrichtung zugeordnet, wobei die Bildpunkte nach Grundfarben aufgezeigte Pixel umfassen und wobei mindestens ein einem Pixel einer Grundfarbe zugeordnetes Bilddatum vor Übermittlung durch ein Überprüfungsdatum ersetzt wird. Dies ist insbesondere dann von Vorteil, zumindest ein Bilddatum des Pixels nur einen geringfügigen oder unwesentlichen Einfluss auf die Darstellung des den Bilddaten zugeordneten Bildes ausübt oder wenn der Einfluss auf die Darstellung des Bildes nur eine unwesentliche oder geringfügige Änderung in der Sehwahrnehmung des Bildes durch den menschlichen Beobachter zur Folge hat.

Erfindungsgemäß umfassen die Pixel nach Grundfarben aufgeteilte Subpixel.

Beispielsweise umfassen die Pixel nach den Grundfarben Rot, Grün und Blau aufgeteilte Subpixel, wobei jeder Pixel jeweils einen Subpixel jeder Grundfarbe für eine additive Farbmischung umfasst. Die Bilddaten umfassen erfindungsgemäß somit die Informationen, in welcher Intensität die zugeordneten Subpixel in den jeweiligen Grundfarben leuchten sollen, wobei diese Intensität als Zahlenwert von beispielsweise acht Bits, also einem Byte, pro Pixel codiert ist. Eine geringfügige Änderung eines Zahlenwerts einer Intensität hat eine entsprechend geringfügige Änderung der Leuchtintensität des betroffenen Pixels und somit nur eine geringfügige Änderung der Farbmischung des zugehörigen Bildpunkts zur Folge. Da der Zahlenwert für die Farbintensität jedes Subpixels Bitfolge codiert ist, hängt ein Ausmaß einer Änderung des durch diese Bits codierten Zahlenwerts von der Stellung des einen oder der mehreren Bits ab, die geändert werden. Jedem Bit kann somit eine Bitwertigkeit, insbesondere eine zu den anderen Bits relative Bitwertigkeit, zugewiesen werden, welche ein Maß für den Einfluss einer Änderung des Bits auf den codierten Zahlenwert angibt. Somit können vorzugsweise einige oder alle Bits zumindest einer Grundfarbe mit einer Bitwertigkeit unterhalb eines vorgegebenen Schwellwerts durch Überprüfungsdaten ersetzt werden. Das Ersetzen dieser Bits hat eine Reduzierung der Farbtiefe des durch die Bilddaten dargestellten Bildes zur Folge, welche jedoch vorteilhafterweise aufgrund der durch die geringe Bitwertigkeit bedingten geringfügigen Änderung in der Darstellung des Bildes in der Regel vernachlässigbar ist. Erfindungsgemäß werden die vier Bits mit der geringsten Bitwertigkeit aller Subpixel zumindest einer Farbe durch Überprüfungsdaten ersetzt.

Gemäß einer weiteren Ausgestaltung der Erfindung werden die Bilddaten kodiert und die Überprüfungsdaten zumindest teilweise in Form von Paritätsbits zu den kodierten Bilddaten übermittelt. Abhängig von jeweiligen Kodierungsalgorithmus kann vorteilhafterweise eine Menge von zusätzlich übertragenen Überprüfungsdaten gering gehalten werden und/oder eine hohe Fehlererkennungsstärke durch den Kodierungsalgorithmus realisiert werden.

Vorzugsweise erfolgt eine Kodierung der Bilddaten und eine Erzeugung der Paritätsbits über eine Hamming-Kodierung. Die Verwendung des Hamming-Codes hat den besonderen Vorteil, dass nicht nur eine Fehlererkennung in den Bilddaten sondern auch eine Fehlerkorrektur übertragener Datenbits in einem vorgegebenen Ausmaß möglich ist.

Gemäß einer besonders vorteilhaften Weiterbildung der Erfindung wird zusätzlich zur Feststellung der ersten Gültigkeit der Bilddaten aus den Bilddaten ein Prüfwert gebildet, wobei der ermittelte Prüfwert mit einem gespeicherten Prüfwert verglichen wird, wobei eine zweite Gültigkeit der Bilddaten nur dann festgestellt wird, wenn der ermittelte und der gespeicherte Prüfwert übereinstimmen. Die Feststellung der zweiten Gültigkeit über den Vergleich von Prüfwerten hat den Vorteil, dass zusätzlich zu einer Gültigkeitsprüfung unter Verwendung der Überprüfungsdaten eine weitere Überprüfung auf Fehler in den übermittelten Bilddaten erfolgt. Dies ist insbesondere dann vorteilhaft, wenn nur ein Teil der Bilddaten mittels der Überprüfungsdaten überprüft werden können oder wenn bei mehreren auftretenden Fehlern in einem Teil der Bilddaten eine Überprüfung und/oder Korrektur dieses Teils der Bilddaten nicht möglich ist. Wird beispielsweise eine Hammingcodierung für die Feststellung der ersten Gültigkeit verwendet, so können abhängig von der Anzahl der als Überprüfungsdaten übermittelten Paritätsbits nur eine bestimmte Anzahl von Bitfehlern erkannt beziehungsweise behoben werden. Ein Auftreten einer höheren Anzahl von Fehlern kann in diesem Fall vorteilhafterweise über den Vergleich der Prüfwerte erkannt werden.

Beispielsweise wird der Prüfwert nach Feststellung der ersten Gültigkeit der Bilddaten für eine Feststellung der zweiten Gültigkeit gebildet. Dies hat den Vorteil, dass während der Feststellung der ersten Gültigkeit erkannte und behebbare Fehler vor Bildung des Prüfwerts korrigiert werden können und somit behebbare Fehler die Feststellung der zweiten Gültigkeit nicht beeinflussen. , Hierbei kann, wie oben beschrieben, eine erste Gültigkeit insbesondere auch bei einem Auftreten von tolerierbaren Fehlern vorliegen, wobei diese tolierbaren Fehler insbesondere auch bei der Feststellung der zweiten Gültigkeit berücksichtigt werden.

Alternativ können die Feststellung der ersten Gültigkeit und die Feststellung der zweiten Gültigkeit auch parallel, insbesondere zeitgleich, durchgeführt werden. Dies ist insbesondere dann vorteilhaft, wenn unter Einbeziehung der Überprüfungsdaten und durch die Prüfwertbildung jeweils unterschiedliche Arten oder Typen von Fehlern in den Bilddaten erkannt werden können und somit eine komplementäre Fehlerüberprüfung zumindest eines Teils der Bilddaten ermöglicht wird.

In einer vorteilhaften Ausgestaltung umfassen die Bilddaten zeitlich beabstandet empfangene Bilddatenpakete, wobei für jedes Bilddatenpaket die erste Gültigkeit und die zweite Gültigkeit überprüft werden und wobei nur dann eine Fehlermeldung generiert wird, wenn eine erste Häufigkeit einer festgestellten ersten Gültigkeit und/oder eine zweite Häufigkeit einer festgestellten zweiten Gültigkeit einen vorgegebenen Schwellwert unterschreiten. Dies hat den Vorteil, dass abhängig von der vorgegebenen Häufigkeit einzelne oder mehrere Bilddatenpakete Übertragungs- oder Darstellungsfehler aufweisen dürfen, ohne dass eine Fehlermeldung generiert wird.

Gemäß einer vorteilhaften Weiterbildung des Verfahrens wird die für die Anzeige der Bilddaten eingerichtete Anzeigevorrichtung zumindest teilweise abgeschaltet, wenn die erste Gültigkeit und/oder die zweite Gültigkeit der Bilddaten nicht festgestellt wird bzw. wenn die Fehlermeldung generiert wird. Unter einer Abschaltung der Anzeigevorrichtung kann insbesondere eine Abschaltung einer Beleuchtung der Anzeigevorrichtung und/oder eine Unterbrechung einer Darstellung von Bilddaten durch die Anzeigevorrichtung verstanden werden, beispielsweise indem unabhängig von der Anzeigevorrichtung empfangenen Bilddaten ein einheitlicher Farbton, insbesondere ein schwarzer Farbton, durch die Anzeige wiedergegeben wird. Durch diese Weiterbildung wird vorteilhafterweise verhindert, dass einem Betrachter der Anzeigevorrichtung fehlerhafte oder sogar irreführende Bilder aus fehlerbehafteten Bilddaten angezeigt werden.

Die Erfindung betrifft auch ein Datenüberwachungsmodul für eine Anzeigevorrichtung. Das Datenüberwachungsmodul ist eingerichtet, eine erste Gültigkeit von Pixeln der Anzeigevorrichtung zugeordneten Bilddaten nur dann festzustellen, wenn bei einer Überprüfung zumindest eines Teils der Bilddaten unter Einbeziehung von Überprüfungsdaten keine Fehler in dem Teil der Bilddaten festgestellt werden oder wenn bei der Überprüfung festgestellte Fehler in dem Teil der Bilddaten unter Berücksichtigung der Überprüfungsdaten zumindest in einem vorgegebenen Ausmaß behoben werden können.

Die Erfindung betrifft ferner eine Anzeigevorrichtung mit einem erfindungsgemäßen Datenüberwachungsmodul. Das Datenüberwachungsmodul kann dabei in der Anzeigevorrichtung zwischen einem Grafikprozessor zum Erstellen der Bilddaten und einem Display zur Darstellung der Bilddaten angeordnet sein, so dass eine Übermittlung der Bilddaten vom Grafikprozessor über das Datenüberwachungsmodul an das Display erfolgt. Alternativ kann das Display für einen Empfang der Bilddaten auch direkt mit dem Grafikprozessor verbunden sein. In letzterem Fall kann das Datenüberwachungsmodul über eine separate Datenleitung mit dem Grafikprozessor, einem Speicher des Displays oder der Verbindung zwischen dem Grafikprozessor und dem Display verbunden sein.

### Kurze Beschreibung der Zeichnungen

Ausführungsbeispiele der Erfindung sind in den Zeichnungen schematisch dargestellt und in der nachfolgenden Beschreibung näher erläutert. Für die in den verschiedenen Figuren dargestellten und ähnlich wirkenden Elemente werden gleiche Bezugszeichen verwendet, wobei auf eine wiederholte Beschreibung der Elemente verzichtet wird.

Es zeigen
- Figur 1: eine schematische Darstellung eines Ausführungsbeispiels des erfindungsgemäßen Verfahrens und
- Figur 2: eine schematische Darstellung eines Ausführungsbeispiels des erfindungsgemäßen Datenüberwachungsmoduls und der erfindungsgemäßen Anzeigevorrichtung.

### Ausführungsformen der Erfindung

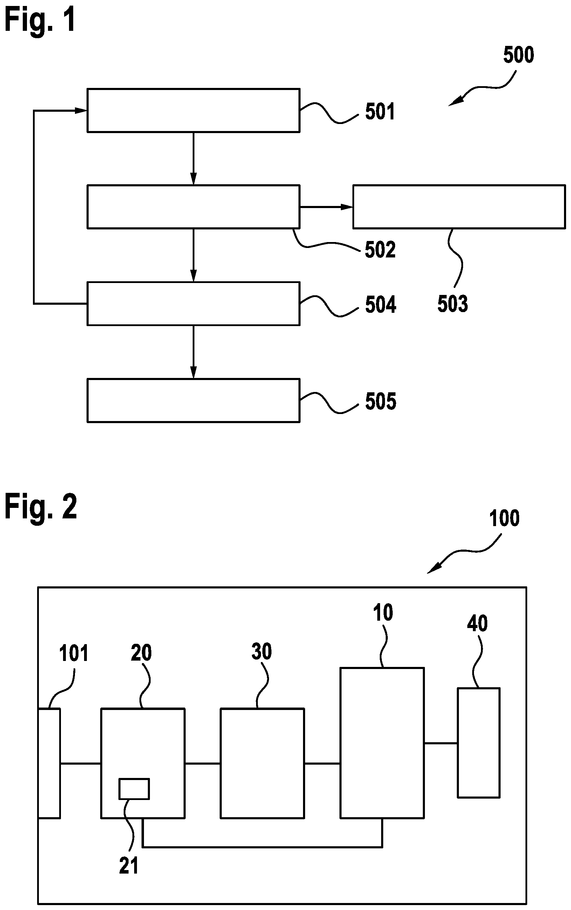

Figur 1 zeigt ein Ausführungsbeispiel des erfindungsgemäßen Verfahrens 500 in Form eines Flussdiagramms. In einem ersten Schritt 501 werden in einem Graphikprozessor erzeugte Bilddaten von einem Datenüberwachungsmodul einer Anzeigevorrichtung empfangen. Dabei können die Bilddaten in periodischen Zeitabständen als Bilddatenpakete, auch Bildframes genannt, empfangen werden. Beispielsweise umfassen die Bilddaten Informationen für die Darstellung eines Warnsymbols in einem Display der Anzeigevorrichtung. Die Bilddaten sind dabei Pixeln von Bildpunkten des Displays zugeordnet, wobei die Pixel nach den Grundfarben Rot, Grün und Blau aufgeteilte Subpixel umfassen. Beispielsweise umfasst jeder Bildpunkt und somit jeder Pixel jeweils einen Subpixel jeder Grundfarbe für eine additive Farbmischung. Die Bilddaten umfassen somit die Informationen, in welcher Intensität die zugeordneten

Subpixel in den jeweiligen Grundfarben leuchten sollen, wobei diese Intensität als Zahlenwert in Form eines Bytes pro Subpixel codiert ist.

Eine geringfügige Änderung eines Zahlenwerts einer Intensität hat eine entsprechend geringfügige Änderung der Leuchtintensität des betroffenen Subpixels und somit nur eine geringfügige Änderung der Farbmischung des zugehörigen Bildpunkts zur Folge. Da jedes Byte als achtstellige Bitfolge codiert ist, hängt ein Ausmaß einer Änderung des durch das Byte codierten Zahlenwerts von der Stellung des einen oder der mehreren Bits ab, die geändert werden. Jedem Bit kann somit eine Bitwertigkeit, insbesondere eine zu den anderen Bits eines Bytes relative Bitwertigkeit, zugewiesen werden, welche ein Maß für den Einfluss einer Änderung des Bits auf den durch das gesamte Byte codierten Zahlenwert angibt. Eine durch eine fehlerhafte Übertragung der Bits verursachte Änderung in einem oder mehreren Bits mit geringer Bitwertigkeit hat somit nur geringen Einfluss auf den codierten Zahlenwert und damit nur geringen Einfluss auf die Farbmischung des zugehörigen Bildpunkts. Daher sind in diesem Ausführungsbeispiel jeweils die vier Bits mit der geringsten Bitwertigkeit jedes Bytes einer Grundfarbe, beispielsweise Blau, durch Überprüfungsdaten ersetzt. Beispielsweise können drei dieser vier Bits durch Paritätsbits einer (7,3)-Hamming-Codierung besetzt sein, sodass ein einzelner Fehler in einem der vier hochwertigsten Bits erkannt und korrigiert werden kann sowie Fehler in zweien der vier hochwertigsten Bits erkannt werden können. Das erfindungsgemäße vorgegebene Ausmaß der Fehlerbehebung ist in diesem Beispiel somit auf ein fehlerhaftes Bit pro geprüftem Byte festgelegt. Das von der Hamming-Codierung nicht umfasste vierte geringwertige Bit kann Bildinformationen tragen. Die Ersetzung der geringwertigsten Bits durch die Überprüfungsdaten kann dabei bereits bei oder nach der Erzeugung der Bilddaten im Graphikprozessor erfolgen. Zusätzlich oder alternativ zum Ersetzen von Bits der Bilddaten durch Überprüfungsdaten können weitere Überprüfungsdaten während eines Zeitraums, genannt Leerzeit oder Dunkelzeit, vor oder nach zumindest einer teilweisen Übermittlung von Bilddaten vom Graphikprozessor zum Datenüberwachungsmodul übermittelt werden.

Nachdem in dem ersten Schritt 501 die Bilddaten samt den Überprüfungsdaten von dem Datenüberwachungsmodul empfangen wurden, erfolgt in einem zweiten Schritt 502 im Datenüberwachungsmodul die Überprüfen der Bilddaten auf die erste Gültigkeit durch eine Hamming-Decodierung und/oder durch die Verwendung der während der Dunkelzeiten übermittelten Überprüfungsdaten. Werden hierbei Fehler in den Bilddaten festgestellt, die nicht korrigiert werden können, so wird auf einen sicherheitskritischen Fehlers in der Darstellung des Warnsymbols erkannt und das Display in einem dritten Schritt 503 zumindest teilweise abgeschaltet. Unter einer zumindest teilweisen Abschaltung des Displays kann insbesondere eine Abschaltung einer Beleuchtung des Displays und/oder eine Unterbrechung einer Darstellung der Bilddaten in dem Display verstanden werden, beispielsweise indem unabängig von der Anzeigevorrichtung empfangenen Bilddaten ein einheitlicher Farbton, insbesondere ein schwarzer Farbton, in dem Display wiedergegeben wird.

Werden keine Fehler oder keine nicht korrigierbaren Fehler festgestellt, so wird aus den empfangenen Bilddaten in einem vierten Schritt 504 ein Prüfwert gebildet und mit einem gespeicherten Prüfwert für eine Feststellung einer zweiten Gültigkeit der Bilddaten verglichen. Der gespeicherte Prüfwert kann dabei in einem Datenspeicher eines Mikrocontrollers abgelegt sein und für den Vergleich an das Datenüberwachungsmodul übermittelt werden. Alternativ kann der gebildete Prüfwert vom Datenüberwachungsmodul zum Mikrocontroller übermittelt und im Mikrocontroller mit dem dort gespeicherten Prüfwert verglichen werden. Stimmen die beiden Prüfwerte überein, so wird eine Gültigkeit der Bilddaten festgestellt und das Verfahren 500 beginnend mit dem ersten Schritt 501 für das nächste empfangene Bilddatenpaket durchgeführt. Weichen die beiden Prüfwerte voneinander ab, so wird auf einen sicherheitskritischen Fehlers in der Darstellung des Warnsymbols erkannt und das Display in einem fünften Schritt 505 zumindest teilweise abgeschaltet.

Alternativ zu einer sofortigen zumindest teilweisen Abschaltung des Displays bei Erkennung des sicherheitskritischen Fehlers nach Feststellung auf die erste und/oder zweite Gültigkeit kann auch nur dann das Display abgeschaltet werden, wenn mehrere Bilddatenpakete auf eine erste und/oder zweite Gültigkeit überprüft wurden und eine Häufigkeit einer ersten und/oder zweiten festgestellten Gültigkeit der Bilddaten einen vorgegebenen Schwellwert unterschreitet.

Alternativ zu den nacheinander erfolgenden Feststellungen der ersten und zweiten Gültigkeit können die beiden Feststellungen, d.h. der zweite Schritt 502 und der vierte Schritt 504, auch parallel erfolgen. In diesem Fall kann das Display beispielsweise dann abgeschaltet werden, wenn zumindest bei einer der beiden Feststellungen ein nicht behebbarer Fehler in den Bilddaten festgestellt wird.

Alternativ zu einer sofortigen Abschaltung des Displays kann eine Abschaltung erst dann erfolgen, wenn eine erste Häufigkeit einer festgestellten ersten Gültigkeit und/oder eine zweite Häufigkeit einer festgestellten zweiten Gültigkeit einen vorgegebenen Schwellwert unterschreiten.

Figur 2 zeigt ein Ausführungsbeispiel des erfindungsgemäßen Datenüberwachungsmoduls 10 als Teil einer erfindungsgemäßen Anzeigevorrichtung 100. Die Anzeigevorrichtung 100 umfasst ferner ein mit dem Datenüberwachungsmodul 10 verbundenes Display 40 sowie einen Mikrocontroller 20, welcher über einen Graphikprozessor 30 der Anzeigevorrichtung 100 mit dem Datenüberwachungsmodul 10 verbunden ist. Für eine Kommunikation mit anderen Geräten weist die Anzeigevorrichtung 100 eine mit dem Mikrocontroller 20 verbundene Schnittstelle 101 auf.

Das zu Figur 1 dargestellte Ausführungsbeispiel des erfindungsgemäßen Verfahrens kann mittels des in Figur 2 dargestellten Ausführungsbeispiels der erfindungsgemäßen Anzeigevorrichtung 100 ausgeführt werden. Dabei ist das Datenüberwachungsmodul 10 eingerichtet, eine erste Gültigkeit von Pixeln der Anzeigevorrichtung 100 zugeordneten Bilddaten nur dann festzustellen, wenn bei einer Überprüfung zumindest eines Teils der Bilddaten unter Einbeziehung der Überprüfungsdaten keine Fehler in dem Teil der Bilddaten festgestellt werden oder wenn bei der Überprüfung festgestellte Fehler in dem Teil der Bilddaten unter Berücksichtigung der Überprüfungsdaten zumindest in einem vorgegebenen Ausmaß behoben werden können. Die Bilddaten und die zugehörigen Überprüfungsdaten werden in diesem Beispiel im Graphikprozessor 30 erzeugt und nach der Hamming-Codierung an das Datenüberwachungsmodul 10 übermittelt. Im Mikrocontroller 20 kann der für die Feststellung der zweiten Gültigkeit erforderlich gespeicherte Prüfwert in einem Datenspeicher 21 des Mikrocontrollers 20 abgelegt sein. Sowohl der Mikrocontroller 20 als auch das Datenüberwachungsmodul 10 können dabei für den Vergleich der Prüfwerte eingerichtet sein und sind für diesen Zweck vorzugsweise direkt miteinander verbunden. Das Datenüberwachungsmodul 10 ist in diesem Beispiel eingerichtet, das Display 40 zumindest teilweise auszuschalten, wenn durch den Vergleich festgestellt wird, dass die beiden Prüfwerte nicht übereinstimmen. Bei Übereinstimmung der Prüfwerte ist das Datenüberwachungsmodul 10 eingerichtet, die Bilddaten für eine Anzeige des Warnsymbols an das Display 40 weiterzuleiten.

## Patentansprüche

1. Verfahren zum Überprüfen einer ersten Gültigkeit von Bilddaten zur Darstellung in einer Anzeigevorrichtung (100) mit einem Graphikprozessor (30), einem Datenüberwachungsmodul (10) und einem Display (40), wobei die Bilddaten Farbwerte für einzelne Pixel des Displays (40) umfassen,
wobei die Pixel nach Grundfarben aufgeteilte Subpixel umfassen und wobei die Bilddaten Informationen umfassen, in welcher Intensität die zugeordneten Subpixel in den jeweiligen Grundfarben leuchten sollen, wobei diese Intensität als Zahlenwert von acht Bits, also einem Byte, pro Pixel codiert ist,
wobei vom Graphikprozessor (30) zu den Bilddaten zugehörige Überprüfungsdaten erzeugt werden, welche Informationen zu einer Überprüfung einer Gültigkeit zumindest eines Teils der Bilddaten tragen,
wobei die vier Bits mit der geringsten Bitwertigkeit aller Subpixel zumindest einer Grundfarbe in den Bilddaten vor einer Übermittlung vom Graphikprozessor durch die Überprüfungsdaten ersetzt werden,
wobei die die Überprüfungsdaten enthaltenden Bilddaten vom Graphikprozessor (30) zu einem Datenüberwachungsmodul (10) übermittelt und von diesem empfangen werden und
wobei vom Datenüberwachungsmodul (10) die erste Gültigkeit der Bilddaten nur dann festgestellt wird, wenn bei einer Überprüfung zumindest eines zu prüfenden Teils der empfangenen nicht-ersetzten Bilddaten anhand der empfangenen Überprüfungsdaten keine Fehler in dem zu prüfenden Teil der empfangenen nicht-ersetzten Bilddaten festgestellt werden oder wenn bei der Überprüfung festgestellte Fehler in dem zu prüfenden Teil der empfangenen nicht-ersetzten Bilddaten mittels der empfangenen Überprüfungsdaten zumindest in einem vorgegebenen Ausmaß behoben werden können.

2. Verfahren nach Anspruch 1, wobei die Überprüfungsdaten zumindest teilweise während einer Zeitdauer vor oder nach zumindest einer teilweisen Übermittlung von Bilddaten übermittelt werden.

3. Verfahren nach einem der vorhergehenden Ansprüche, wobei die Bilddaten codiert und die Überprüfungsdaten zumindest teilweise in Form von Paritätsbits zu den codierten Bilddaten übermittelt werden.

4. Verfahren nach Anspruch 2, wobei eine Codierung der Bilddaten und eine Erzeugung der Paritätsbits über eine Hamming-Codierung erfolgt.

5. Verfahren nach einem der vorhergehenden Ansprüche, wobei zusätzlich zur Feststellung der ersten Gültigkeit der Bilddaten aus den empfangenen nicht-ersetzten Bilddaten ein Prüfwert gebildet wird, wobei der ermittelte Prüfwert mit einem gespeicherten Prüfwert verglichen wird, wobei eine zweite Gültigkeit der Bilddaten nur dann festgestellt wird, wenn der ermittelte und der gespeicherte Prüfwert übereinstimmen, wobei der gespeicherte Prüfwert in einem Datenspeicher eines Mikrocontrollers(20) der Anzeigevorrichtung (100) abgelegt ist und für den Vergleich an das Datenüberwachungsmodul (10) übermittelt wird.

6. Verfahren nach Anspruch 4, wobei die Feststellung der ersten Gültigkeit der Bilddaten und die Feststellung der zweiten Gültigkeit der Bilddaten parallel durchgeführt werden.

7. Verfahren nach Anspruch 4, wobei die Feststellung zweiten der Gültigkeit der Bilddaten nach der Feststellung der ersten Gültigkeit der Bilddaten durchgeführt wird.

8. Verfahren nach einem den Ansprüche 4 bis 6, wobei die Bilddaten zeitlich beabstandet empfangene Bilddatenpakete umfassen, wobei für jedes Bilddatenpaket die erste Gültigkeit und die zweite Gültigkeit überprüft werden und wobei nur dann eine Fehlermeldung generiert wird, wenn eine erste Häufigkeit einer festgestellten ersten Gültigkeit und/oder eine zweite Häufigkeit einer festgestellten zweiten Gültigkeit einen vorgegebenen Schwellwert unterschreiten.

9. Verfahren nach einem der vorhergehenden Ansprüche, wobei das für die Anzeige der Bilddaten eingerichtete Display (40) zumindest teilweise abgeschaltet wird, wenn die erste Gültigkeit und/oder die zweite Gültigkeit der Bilddaten nicht festgestellt wird beziehungsweise wenn die Fehlermeldung generiert wird.

10. Anzeigevorrichtung (100) mit einem Graphikprozessor (30), einem Datenüberwachungsmodul (10) und einem Display (40) dazu eingerichtet, das Verfahren nach einem der Ansprüche 1 bis 9 auszuführen.

## Claims

1. Method for checking a first validity of image data for presentation in a display device (100) comprising a graphics processor (30), a data monitoring module (10) and a display (40), wherein the image data comprise colour values for individual pixels of the display (40), wherein the pixels comprise subpixels divided according to primary colours and wherein the image data comprise information regarding the intensity with which the assigned subpixels are intended to be luminous in the respective primary colours, wherein said intensity is encoded as a numerical value of eight bits, i.e. one byte, per pixel,
wherein checking data associated with the image data are generated by the graphics processor (30) and carry information concerning a checking of a validity of at least one portion of the image data, wherein the four bits having the least bit significance of all the subpixels of at least one primary colour in the image data are replaced by the checking data before a transmission by the graphics processor,
wherein the image data containing the checking data are transmitted from the graphics processor (30) to a data monitoring module (10) and are received by the latter, and
wherein the first validity of the image data is ascertained by the data monitoring module (10) only if, during a checking of at least one portion to be checked of the received non-replaced image data on the basis of the received checking data, no errors are ascertained in the portion to be checked of the received non-replaced image data or if errors ascertained during the checking in the portion to be checked of the received non-replaced image data, by means of the received checking data, can be corrected at least to a predefined extent.

2. Method according to Claim 1, wherein the checking data are transmitted at least in part during a time period before or after at least a partial transmission of image data.

3. Method according to either of the preceding claims, wherein the image data are encoded and the checking data are transmitted at least in part in the form of parity bits with respect to the encoded image data.

4. Method according to Claim 2, wherein an encoding of the image data and a generation of the parity bits are effected by way of a Hamming encoding.

5. Method according to any of the preceding claims, wherein in addition to ascertaining the first validity of the image data, from the received non-replaced image data, a check value is formed, wherein the determined check value is compared with a stored check value, wherein a second validity of the image data is ascertained only if the determined check value and the stored check value match, wherein the stored check value is stored in a data memory of a microcontroller (20) of the display device (100) and is transmitted to the data monitoring module (10) for the comparison.

6. Method according to Claim 4, wherein ascertaining the first validity of the image data and ascertaining the second validity of the image data are carried out in parallel.

7. Method according to Claim 4, wherein ascertaining the second validity of the image data is carried out after ascertaining the first validity of the image data.

8. Method according to any of Claims 4 to 6, wherein the image data comprise image data packets that are received in a manner spaced apart over time, wherein the first validity and the second validity are checked for each image data packet and wherein an error message is generated only if a first frequency of an ascertained first validity and/or a second frequency of an ascertained second validity fall(s) below a predefined threshold value.

9. Method according to any of the preceding claims, wherein the display (40) configured for displaying the image data is at least partly switched off if the first validity and/or the second validity of the image data are/is not ascertained or if the error message is generated.

10. Display device (100) comprising a graphics processor (30), a data monitoring module (10) and a display (40) configured to carry out the method according to any of Claims 1 to 9.

## Revendications

1. Procédé de vérification d'une première validité de données d'image à présenter dans un dispositif d'affichage (100) comprenant un processeur graphique (30), un module de surveillance de données (10) et un affichage (40), les données d'image comprenant des valeurs de couleur destinées à des pixels individuels de l'affichage (40), les pixels comprenant des sous-pixels divisés selon les couleurs primaires et les données d'image comprenant des informations sur l'intensité avec laquelle les sous-pixels associés doivent s'éclairer dans les couleurs primaires respectives, cette intensité étant codée sous la forme d'une valeur numérique de huit bits, soit un octet, par pixel,
des données de vérification associées aux données d'image étant générées par le processeur graphique (30) et portant des informations relatives à la vérification de la validité d'au moins une partie des données d'image,
les quatre bits de plus faible poids de tous les sous-pixels d'au moins une couleur primaire dans les données d'image étant remplacés par les données de vérification avant la transmission par le processeur graphique,
les données d'image contenant les données de vérification étant transmises du processeur graphique (30) à un module de surveillance de données (10) et reçues par celui-ci, et
le module de surveillance de données (10) ne déterminant la première validité des données d'image que si, lors d'une vérification d'au moins une partie à vérifier des données d'image non-remplacées reçues sur la base des données de vérification reçues, aucune erreur n'est constatée dans la partie à vérifier des données d'image non-remplacées reçues ou si des erreurs constatées pendant la vérification dans la partie à vérifier des données d'image non-remplacées reçues peuvent être éliminées au moins dans une mesure spécifiée au moyen des données de vérification reçues.

2. Procédé selon la revendication 1, les données de vérification étant transmises au moins partiellement pendant une durée avant ou après au moins une transmission partielle de données d'image.

3. Procédé selon l'une des revendications précédentes, les données d'image étant codées et les données de vérification étant transmises au moins partiellement sous la forme de bits de parité aux données d'image codées.

4. Procédé selon la revendication 2, les données d'image étant codées et les bits de parité étant générés par un codage de Hamming.

5. Procédé selon l'une des revendications précédentes, une valeur de test étant formée à partir des données d'image non-remplacées reçues en plus de la détermination de la première validité des données d'image, la valeur de test déterminée étant comparée à une valeur de test mémorisée, une deuxième validité des données d'image n'étant constatée que si la valeur de test déterminée et la valeur de test mémorisée correspondent, la valeur de test mémorisée étant stockée dans une mémoire de données d'un microcontrôleur (20) du dispositif d'affichage (100) et étant transmise au module de surveillance de données (10) pour comparaison.

6. Procédé selon la revendication 4, la détermination de la première validité des données d'image et la détermination de la deuxième validité des données d'image étant effectuées en parallèle.

7. Procédé selon la revendication 4, la détermination de la deuxième validité des données d'image étant effectuée après la détermination de la première validité des données d'image.

8. Procédé selon l'une des revendications 4 à 6, les données d'image comprenant des paquets de données d'image reçus à des instants différents, la première validité et la deuxième validité étant vérifiées pour chaque paquet de données d'image et
un message d'erreur n'étant généré que si une première fréquence d'une première validité constatée et/ou une deuxième fréquence d'une deuxième validité constatée deviennent inférieures à une valeur de seuil spécifiée.

9. Procédé selon l'une des revendications précédentes, l'affichage (40) conçu pour afficher les données d'image étant au moins partiellement désactivé si la première validité et/ou la deuxième validité des données d'image n'est pas déterminée ou si le message d'erreur est généré.

10. Dispositif d'affichage (100) comprenant un processeur graphique (30), un module de surveillance de données (10) et un affichage (40) conçu pour mettre en œuvre le procédé selon l'une des revendications 1 à 9.
